# FASCICULE DE BREVET EUROPEEN

(11) **EP 3 971 979 B1**
(45) Date de publication et mention de la délivrance du brevet: **07.05.2025**
(21) Numéro de dépôt: 21195907.7
(22) Date de dépôt: 10.09.2021
(51) Int. Cl.: H01L 27/146

(54) **CIRCUIT MICROELECTRONIQUE TRIDIMENSIONNEL A REPARTITION OPTIMISEE DE SES FONCTIONS NUMERIQUE ET ANALOGIQUE**
DREIDIMENSIONALE MIKROELEKTRONISCHE SCHALTUNG MIT OPTIMIERTER VERTEILUNG IHRER DIGITALEN UND ANALOGEN FUNKTIONEN
THREE-DIMENSIONAL MICROELECTRONIC CIRCUIT WITH OPTIMISED DISTRIBUTION OF ITS DIGITAL AND ANALOGUE FUNCTIONS

(30) Priorité: 18.09.2020 FR 2009492
(43) Date de publication de la demande: 23.03.2022
(73) Titulaire: Commissariat à l'Energie Atomique et aux Energies Alternatives, 75015 Paris (FR)
(72) Inventeur: SICARD, Gilles, 38054 GRENOBLE CEDEX 09 (FR); BATUDE, Perrine, 38054 GRENOBLE CEDEX 09 (FR); LATTARD, Didier, 38054 GRENOBLE CEDEX 09 (FR)
(74) Mandataire: Brevalex

(56) Documents cités:
- TW-A- 201 842 660
- US-A1- 2009 242 950
- US-A1- 2010 276 572

## Description

### DOMAINE TECHNIQUE

L'invention concerne le domaine de la conception et de la fabrication de circuits microélectroniques de structure tridimensionnelle ou 3D, c'est-à-dire formés de plusieurs niveaux de circuit (correspondant au terme anglais « tier » couramment utilisé) qui correspondent chacun à un circuit microélectronique plan ou 2D et qui sont empilés les uns sur les autres et connectés électriquement entre eux de manière localisée, c'est-à-dire par l'intermédiaire d'interconnexions électriques réalisées au sein des circuits microélectroniques.

L'invention s'applique avantageusement à la réalisation de capteurs ou d'imageurs matriciels, mais également à tout type de circuit microélectronique comportant une matrice de dispositifs et intégrant des fonctions électroniques analogiques et numériques.

### ÉTAT DE LA TECHNIQUE ANTÉRIEURE

Dans un capteur matriciel, par exemple un capteur d'images, réalisé sous la forme d'un circuit microélectronique 2D, l'ensemble des fonctions électroniques du capteur sont intégrées de manière monolithique avec une matrice de détecteurs du capteur dans une même couche de semi-conducteur. D'un point de vue performances du capteur, on souhaite en général réduire la dimension (le pas) des pixels photosensibles, améliorer sa vitesse d'acquisition, sa sensibilité et sa dynamique d'entrée, et réduire sa consommation électrique. Le document US2009/242950A décrit des capteurs d'image.

La réalisation de circuits microélectroniques avec une structure 3D présente plusieurs avantages. Ainsi, la proximité entre les différents circuits 2D superposés formant le circuit 3D permet d'obtenir un gain en performances important, du fait notamment de la réduction des longueurs des interconnexions électriques entre les différentes fonctions du circuit ou encore la possibilité d'implémenter les fonctions électroniques de manière plus parallélisée. Un autre avantage apporté par la structure 3D est la possibilité de répartir les fonctions (numérique, analogique, détection) du circuit 3D sur différents niveaux suivant leurs spécificités. Ainsi, il est possible de choisir, pour la réalisation des composants mettant en œuvre chaque fonction, la technologie la plus adéquate et optimiser les performances de chaque circuit 2D dédié à chaque fonction indépendamment des autres.

Une première technique de réalisation de circuits microélectroniques 3D consiste à réaliser en parallèle différentes parties du circuit 3D sous la forme de plusieurs circuits 2D à partir de différents wafers, puis à superposer et interconnecter ces circuits 2D par des interconnexions électriques de type TSV (« Through Silicon Via » en anglais) ou des micro-billes ou des plots métalliques. Une telle technologie est appelée intégration 3D parallèle ou « 3D stacking » ou « 3D packaging » en anglais.

Le document [1] de T. Takahashi et al., "A 4.1Mpix 280fps Stacked CMOS Image Sensor with Array-Parallel ADC Architecture for Region Control", IEEE Symposium on VLSI Circuits (VLSI 2017), Kyoto, Japan, 5-8 juin 2017, propose un imageur comprenant deux couches de semi-conducteur, ou deux niveaux, avec des interconnexions électriques de type matricielle entre ces deux niveaux et dans lequel plusieurs convertisseurs analogique - numérique (CAN) adressent chacun un groupe de pixels. Par rapport à un capteur d'image 2D, la vitesse d'acquisition est grandement améliorée tout en conservant une consommation électrique raisonnable. Ce capteur est réalisé par intégration 3D parallèle.

Le document [2] US 2017/0338268 A1 décrit également un imageur 3D comprenant un empilement de deux niveaux réalisé par intégration 3D parallèle, avec la réalisation des éléments de photodétection dans une première couche de semi-conducteur et la réalisation d'un circuit numérique dans une deuxième couche de semi-conducteur.

Le document [3] de L. Millet et al., "A 5500fps 85GOPS/W 3D stacked BSI vision chip based on parallel in-focal-plane acquisition and processing", IEEE Symposium on VLSI Circuits, Hawaï, USA, 18-22 juin 2018, propose la réalisation d'un imageur par intégration 3D parallèle, comprenant une connexion matricielle dense qui permet, grâce à une couche dans laquelle est réalisé un circuit numérique de calcul, d'atteindre de très bonnes performances d'acquisition et de traitement d'images. Le circuit numérique de calcul est réalisé avec la même technologie que la matrice de détection de l'imageur.

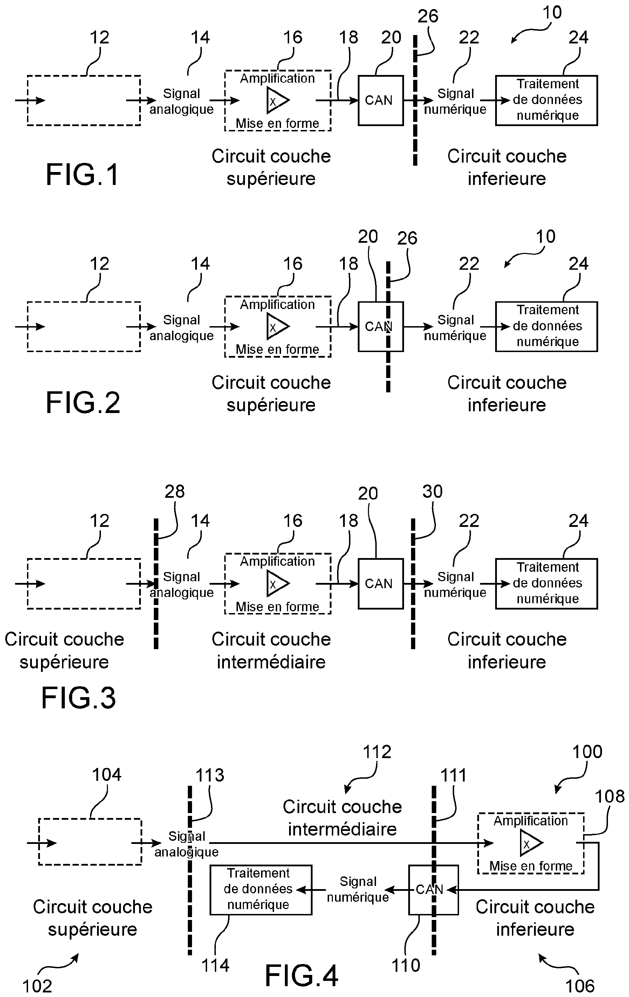

La figure 1 représente schématiquement le chemin de données acquises au sein d'un capteur d'image 10 comportant deux couches, comme dans les documents [1] à [3] précédemment cités, et réalisé par intégration 3D parallèle.

Un signal, par exemple un signal lumineux, est tout d'abord acquis par une matrice de détecteurs 12 du capteur 10. Ces détecteurs 12 correspondent à des éléments photosensibles, par exemple des photodiodes (jonctions PN), des phototransistors ou encore des photodiodes associées à des portes de transfert. La matrice de détecteurs 12 délivre des signaux analogiques 14 qui sont envoyés en entrée d'un circuit analogique 16 d'amplification et de mise en forme de ces signaux analogiques 14. Des signaux 18 (qui sont analogiques) délivrés par le circuit analogique 16 sont envoyés en entrée de convertisseurs analogique - numérique 20 qui convertissent les signaux 18 en signaux numériques 22. Les signaux numériques 22 sont ensuite envoyés en entrée d'un circuit numérique de traitement 24 des signaux 22. Bien que non représentés, le capteur 10 comporte généralement d'autres éléments tels qu'un décodeur de lignes couplé à la matrice de détecteurs 12, un multiplexeur dont les entrées sont couplées aux sorties des convertisseurs analogique - numérique 20 et dont la sortie est couplée à l'entrée du circuit numérique de traitement 24, ainsi qu'un circuit numérique de contrôle commandant ou pilotant la matrice de détecteurs 12.

Dans un tel capteur 10, la matrice de détecteurs 12, le circuit analogique 16 et les convertisseurs analogique - numérique 20 sont réalisés dans une couche de semi-conducteur supérieure du capteur 10, et le circuit numérique de traitement 24 est réalisé dans une couche de semi-conducteur inférieure du capteur 10. Le trait pointillé portant la référence 26 représente symboliquement la frontière entre la couche supérieure et la couche inférieure. Dans une telle configuration, ces éléments du capteur 10 (matrice de détecteurs 12, circuit analogique 16, convertisseurs analogique - numérique 20, circuit numérique 24) peuvent être similaires à ceux d'un capteur 2D. Seules les couches de métallisations formant les interconnexions entre les deux couches sont spécifiques à un tel capteur 10. Cela est avantageux car des designs, ou architectures, existants de circuits 2D peuvent être réutilisés pour la réalisation des éléments du capteur 10.

En variante, il est possible que les composants électroniques formant les convertisseurs analogique - numérique 20 soient répartis sur les deux couches de semi-conducteur du capteur 10. En effet, ces convertisseurs 20 comportent des composants analogiques et des composants numériques. Les composants analogiques sont dans ce cas réalisés dans la même couche que celle dans laquelle sont réalisés les composants du circuit analogique 16, et les composants numériques sont réalisés dans la même couche que celle dans laquelle sont réalisés les composants du circuit numérique 24. La figure 2 représente schématiquement une telle répartition. Cette variante a pour avantage que les deux types de composants du capteur 10 peuvent être réalisés sur une même couche avec une technologie dédiée adaptée à la réalisation du type de ces composants, ce qui permet d'obtenir de bonnes performances pour tous les composants du capteur 10. Par contre, dans cette variante, il n'est pas possible d'utiliser des designs existants de circuits 2D. Une telle configuration est par exemple décrite dans le document [4] de L. Millet et al. "A 5 Million Frames Per Second 3D Stacked Image Sensor With In-Pixel Digital Storage", IEEE ESSCIRC International Conference, Dresden, Germany, 3-6 septembre 2018.

Le document [5] de T. Haruta et al., « A 1/2.3inch 20Mpixel 3-layer stacked CMOS Image Sensor with DRAM », IEEE International Solid-State Circuits Conference (ISSCC 2017), San Francisco, USA, 5-9 février 2017, décrit un imageur réalisé en technologie 3D. Le capteur est réalisé sur trois niveaux, ou trois couches : un premier niveau dans lequel est réalisé un circuit numérique de traitement, un deuxième niveau dans lequel est réalisé un circuit mémoire RAM et un troisième niveau dans lequel sont réalisés une matrice de détecteurs et les composants analogiques de l'imageur. Les trois niveaux sont réalisés indépendamment les uns des autres et sont ensuite assemblés et interconnectés électriquement entre eux par des interconnexions de type TSV réalisés sur un côté du capteur.

La réalisation de ce capteur d'images par intégration 3D parallèle est avantageuse car les fonctions de détection, de traitement numérique et de traitement analogique sont réparties dans trois circuits distincts superposés. Cette disposition a un impact positif sur la performance globale du circuit 3D et également sur le coût de réalisation d'un tel système intégré.

Toutefois, le principal inconvénient de la technologie 3D parallèle utilisée dans les circuits précédemment décrits est que les interconnexions électriques utilisées pour interconnecter les différents circuits superposés ont des dimensions trop importantes et ne permettent donc pas d'obtenir une forte densité d'interconnexions entre les couches superposées. C'est la raison pour laquelle dans le capteur décrit dans le document [5], les interconnexions sont localisées sur un côté du capteur. De telles interconnexions ne peuvent pas être utilisées pour des architectures de traitement d'images numériques fortement parallèles. Cela limite les architectures possibles aux architectures classiques, ne rendant possible l'amélioration des performances de traitements que par un changement technologique.

Une deuxième technique de réalisation de circuits microélectroniques 3D appelée intégration 3D séquentielle, ou 3D monolithique, se différencie de l'intégration 3D parallèle par le fait qu'elle permet de créer un empilement des deux circuits 2D en construisant ces circuits directement l'un sur l'autre. Par exemple, après avoir fabriqué le premier circuit comportant notamment un niveau de transistors et des lignes d'interconnexions métalliques, un deuxième substrat est reporté sur le premier circuit, par exemple par un collage oxyde-oxyde. Le deuxième substrat est ensuite aminci, puis les transistors du deuxième circuit sont ensuite fabriqués. Les interconnexions électriques entre les deux circuits, formant des contacts 3D également appelés MIV pour « Monolithic Inter-tier Vias » en anglais, sont ensuite réalisées pour créer les interconnexions entre les deux circuits. Enfin, les couches d'interconnexions métalliques du deuxième circuit sont réalisées.

Par rapport à l'intégration 3D parallèle, l'intégration 3D séquentielle permet la réalisation de plus petites interconnexions (dont la section est par exemple de l'ordre de 100 nm) du fait que l'épaisseur de matériau traversée par les contacts de type MIV est bien plus faible que celle traversée par les interconnexions réalisées pour une intégration 3D parallèle. Une forte densité d'interconnexions électriques entre les circuits superposés peut donc être obtenue.

Cependant, dans une telle intégration 3D séquentielle, les transistors du deuxième circuit doivent être fabriqués à plus faible température que la normale (généralement moins de 400°C ou dans certains cas moins de 500°C) afin de ne pas dégrader les performances des transistors du premier circuit.

Le document [6] US 2015/0163425 A1 propose la réalisation d'un capteur d'images en utilisant la technologie 3D séquentielle pour former trois niveaux électroniques. Dans ce capteur, les photodétecteurs sont réalisés dans une couche de semi-conducteur supérieure, un circuit numérique de traitement est réalisé dans une couche de semi-conducteur inférieure, et des convertisseurs analogique - numérique sont réalisés dans une couche de semi-conducteur intermédiaire disposée entre les couches inférieure et supérieure. La figure 3 représente schématiquement le chemin des données dans les éléments d'un tel capteur. Dans une telle configuration, une couche de semi-conducteur supérieure est dédiée à la matrice de détecteurs 12, une couche de semi-conducteur inférieure est dédiée aux fonctions numériques (circuit numérique de traitement 24) et une couche de semi-conducteur intermédiaire, disposée entre les couches inférieure et supérieure, est dédiée aux fonctions analogiques (circuit analogique 16 et convertisseurs analogique - numérique 20). Les traits pointillés référencés 28 et 30 représentent symboliquement les frontières entre ces trois couches. Dans un tel capteur, le circuit numérique peut être réalisé tel que ses composants présentent de bonnes performances puisqu'il est réalisé à partir du premier substrat sur lequel seront réalisés les autres éléments. Par contre, les composants analogiques réalisés dans la couche intermédiaire n'auront pas les performances souhaitées étant donné la limitation des températures pouvant être mises en jeu lors de la réalisation de ces composants analogiques, car les étapes mises en œuvre pour réaliser les composants analogiques dans la couche intermédiaire ne doivent pas dégrader les composants du circuit numérique réalisé au préalable dans la couche inférieure.

Les problèmes mentionnés ci-dessus pour un dispositif imageur se retrouvent également dans le cas d'un dispositif de type afficheur ayant une structure 3D, et plus généralement dans tous les circuits microélectroniques ayant une structure 3D et comprenant une matrice de dispositifs disposée au sein d'un niveau de circuit supérieur.

### EXPOSÉ DE L'INVENTION

Un but de la présente invention est de proposer un circuit microélectronique dont l'architecture 3D permette d'optimiser la répartition des composants numériques et analogiques dans un empilement d'au moins trois couches de semi-conducteur, et dans lequel la réalisation des composants analogiques n'impacte pas les performances des composants numériques et inversement.

Pour cela, la présente invention propose un circuit microélectronique comprenant au moins :
- un empilement d'au moins un niveau de circuit inférieur, un niveau de circuit intermédiaire et un niveau de circuit supérieur, distincts les uns des autres et tels que le niveau de circuit intermédiaire soit disposé entre le niveau de circuit inférieur et le niveau de circuit supérieur,
- une matrice de dispositifs réalisée dans le niveau de circuit supérieur, configurés pour délivrer en sortie et/ou recevoir en entrée des signaux électriques analogiques,
- un circuit analogique d'amplification et/ou de traitement réalisé dans le niveau de circuit inférieur,
- un circuit numérique de traitement réalisé dans le niveau de circuit intermédiaire,
- un circuit de conversion analogique-numérique et/ou numérique-analogique formé par des composants microélectroniques réalisés dans le niveau de circuit inférieur et/ou dans le niveau de circuit intermédiaire, et comprenant des entrées et des sorties couplées électriquement à des entrées et/ou des sorties du circuit analogique d'amplification et/ou de traitement ainsi qu'à des entrées et/ou des sorties du circuit numérique de traitement,
- des interconnexions électriques traversant le niveau de circuit intermédiaire et couplant électriquement des entrées et/ou des sorties du circuit analogique d'amplification et/ou de traitement à des entrées et/ou des sorties des dispositifs.

Ce circuit microélectronique comporte un positionnement judicieux des composants analogiques et numériques dans son empilement, qui permet de garantir l'obtention de bonnes performances pour ces composants, tout en minimisant les coûts liés à la réalisation du circuit microélectronique. En effet, les composants du circuit analogique sont réalisés dans le niveau de circuit inférieur qui comporte le substrat initial utilisé lors de la réalisation du circuit microélectronique, et les composants du circuit numérique sont réalisés dans le niveau de circuit intermédiaire. Dans cette configuration, les composants analogiques peuvent être réalisés sans restriction sur les températures mises en jeu lors de leur réalisation, ce qui permet d'obtenir de bonnes performances pour ces composants analogiques, notamment pour les transistors analogiques réalisés : gain intrinsèque important, faible bruit, faible résistance à l'état passant. De plus, les performances des composants numériques, notamment les transistors, ne sont pas limitées à cause des dimensions des interconnexions électriques reliant ces composants aux autres éléments du circuit. Enfin, les dispositifs réalisés dans le niveau de circuit supérieur peuvent également être réalisés avec des performances optimisées.

La structure de ce circuit n'est pas intuitive car contrairement aux capteurs de l'art antérieur, le traitement analogique des données issues des dispositifs de la matrice formée dans le niveau de circuit supérieur n'est pas réalisé dans un niveau de circuit adjacent à celui comportant la matrice de dispositifs.

Dans cette structure, les fonctions sont regroupées par niveau : fonctions analogiques dans le niveau de circuit inférieur, fonctions numériques dans le niveau de circuit intermédiaire, et fonction de détection et/ou émission dans le niveau de circuit supérieur. Une telle répartition est avantageuse en termes de coût de conception du circuit microélectronique.

Il est possible que la matrice de dispositifs comporte à la fois des dispositifs de type détecteur, par exemple des composants photosensibles tels que des photodiodes ou des composants de type NEMS, et des dispositifs de type émetteur, par exemple des LEDs.

Dans ce circuit microélectronique, les transistors analogiques se distinguent des transistors numériques du fait qu'ils sont souvent réalisés avec des dimensions plus importantes, autant pour la longueur de grille que pour la largeur de grille et que pour l'épaisseur de l'oxyde sous la grille. Par exemple, la longueur de grille des transistors analogiques réalisés dans le niveau de circuit inférieur (par exemple égale à 90 nm) peut être trois à cinq fois plus grande que celle des transistors numériques réalisés dans le niveau de circuit intermédiaire (par exemple égale à 28 nm).

Le niveau de circuit intermédiaire peut avoir une épaisseur inférieure à environ 500 nm, et les interconnexions électriques peuvent comporter chacune une section de dimension inférieure à environ 200 nm.

Le lien électrique entre les niveaux de circuit supérieur et inférieur se fait à travers le niveau de circuit intermédiaire. Cependant, ce niveau de circuit intermédiaire étant très fin, les pertes au niveau des interconnexions formant ce lien électrique, qui sont liées à la résistivité et aux capacités parasites du conducteur utilisé, restent minimales.

La dimension d'une section d'une des interconnexions électriques traversant le niveau de circuit intermédiaire correspond à la plus grande dimension de cette interconnexion dans un plan sensiblement parallèle aux faces principales du niveau intermédiaire et qui se trouvent en regard des niveaux de circuit inférieur et supérieur. Par exemple, dans le cas d'une telle interconnexion électrique ayant une section en forme de disque, cette dimension correspond à la diagonale de ce disque. Dans le cas d'une telle interconnexion électrique ayant une section de forme polygonale, cette dimension correspond à la plus grande diagonale de ce polygone.

De manière avantageuse, le circuit de conversion analogique-numérique et/ou numérique-analogique peut comporter des composants microélectroniques analogiques réalisés dans le niveau de circuit inférieur et des composants microélectroniques numériques réalisés dans le niveau de circuit intermédiaire. Ainsi, tous les composants microélectroniques du circuit de conversion analogique-numérique et/ou numérique-analogique peuvent être réalisés avec une technologie optimisée correspondant à celle mise en œuvre lors de la réalisation du circuit analogique d'amplification et/ou de traitement pour les composants analogiques et celle mise en œuvre lors de la réalisation du circuit numérique de traitement pour les composants numériques.

Le nombre d'interconnexions électriques traversant le niveau de circuit intermédiaire et couplant électriquement des entrées et/ou des sorties du circuit analogique d'amplification et/ou de traitement à des entrées et/ou des sorties des dispositifs peut être au moins égal au nombre de dispositifs tel que chaque dispositif soit couplé directement à l'une de ces interconnexions électriques. Ainsi, chaque dispositif peut être relié directement au circuit analogique par l'intermédiaire d'une de ces interconnexions électriques.

En variante, il est possible que chacune de ces interconnexions électriques soit couplée à plusieurs dispositifs formant par exemple une sous-matrice au sein de la matrice formée par tous les dispositifs. Il est également possible que chacune de ces interconnexions électriques soit couplée à une des colonnes ou à une des lignes de la matrice de dispositifs. Dans ce cas, le circuit comporte un nombre plus important de dispositifs que d'interconnexions électriques.

Les dispositifs peuvent comporter des photodétecteurs. Le circuit microélectronique peut correspondre dans ce cas à un imageur ou capteur d'images.

Selon une première configuration :
- le niveau de circuit supérieur peut comporter deux faces principales opposées,
- les photodétecteurs peuvent être couplés électriquement à au moins un niveau de métallisations d'interconnexions disposé du côté d'une première des deux faces principales du niveau de circuit supérieur et en regard du niveau de circuit intermédiaire, et peuvent comporter des surfaces photosensibles disposées du côté d'une deuxième des deux faces principales du niveau de circuit supérieur, ou les photodétecteurs peuvent comporter au moins une couche de photodétection organique ou colloïdale et une couche électriquement conductrice formant des électrodes des photodétecteurs telle que la couche électriquement conductrice soit disposée entre la couche de photodétection et le niveau de circuit intermédiaire (la couche électriquement conductrice est dans ce cas disposée du côté de la première face principale du niveau de circuit supérieur).

Dans cette première configuration, le circuit microélectronique forme un imageur à illumination en face arrière, ou capteur BSI (« backside illumination » en anglais). La deuxième face principale du niveau de circuit supérieur correspond dans ce cas à la surface recevant les photons à détecter.

Selon une deuxième configuration :
- le niveau de circuit supérieur peut comporter deux faces principales opposées,
- les photodétecteurs peuvent être couplés électriquement à au moins un niveau de métallisations d'interconnexions disposé du côté d'une première des deux faces principales du niveau de circuit supérieur, et peuvent comporter des surfaces photosensibles disposées du côté de la première des deux faces principales du niveau de circuit supérieur ou les photodétecteurs peuvent comporter au moins une couche de photodétection organique ou colloïdale et une couche électriquement conductrice formant des électrodes des photodétecteurs telle que la couche de photodétection organique ou colloïdale soit disposée entre la couche électriquement conductrice et le niveau de circuit intermédiaire.

Dans cette deuxième configuration, le circuit microélectronique forme un imageur à illumination en face avant, ou capteur FSI (« frontside illumination » en anglais). La première face principale du niveau de circuit supérieur correspond dans ce cas à la surface recevant les photons à détecter. La deuxième face principale du niveau de circuit supérieur peut se trouver en regard du niveau de circuit intermédiaire.

Dans cette deuxième configuration, lorsque le niveau de circuit supérieur est réalisé par intégration 3D parallèle, le niveau de circuit supérieur peut avoir une épaisseur comprise entre environ 3 µm et 10 µm, et des interconnexions électriques traversant la couche de semi-conducteur supérieure peuvent comporter des sections de dimensions inférieures à environ 500 nm. En variante, lorsque le niveau de circuit supérieur est réalisé par intégration 3D séquentielle, le niveau de circuit supérieur peut avoir une épaisseur inférieure à environ 500 nm, et des interconnexions électriques traversant la couche de semi-conducteur supérieure peuvent comporter des sections de dimensions inférieures à environ 200 nm.

Dans le paragraphe ci-dessus, la dimension d'une section d'une des interconnexions électriques traversant la couche de semi-conducteur supérieure correspond à la plus grande dimension de cette interconnexion dans un plan sensiblement parallèle aux faces principales de la couche supérieure et dont l'une se trouve en regard de la couche de semi-conducteur intermédiaire.

Selon d'autres configurations, les dispositifs semi-conducteurs de la couche supérieure peuvent comporter des diodes électroluminescentes ou des dispositifs MEMS ou NEMS ou des antennes THz (c'est-à-dire aptes à émettre et/ou recevoir des ondes dont les longueurs d'onde ont des valeurs comprises entre 0,1 et 10 THz). A titre d'exemple, la matrice de dispositifs semi-conducteurs peut correspondre à une matrice de dispositifs NEMS permettant de faire des mesures de masse moléculaire.

Le circuit microélectronique peut comporter plusieurs niveaux de circuit intermédiaires distincts, disposés entre les niveaux de circuit inférieur et supérieur et comportant des circuits numériques tels que des circuits mémoires et/ou des circuits de traitement de données, chaque niveau de circuit intermédiaire pouvant avoir une épaisseur inférieure à environ 500 nm, et les interconnexions électriques couplant électriquement des entrées et/ou des sorties du circuit analogique d'amplification et/ou de traitement à des entrées et/ou des sorties des dispositifs peuvent traverser chacun des niveaux de circuit intermédiaire. Ces circuits numériques peuvent être réalisés par intégration 3D séquentielle.

L'invention concerne également un procédé de réalisation d'un circuit microélectronique, comportant au moins les étapes de :
- réalisation, dans un niveau de circuit inférieur comportant un premier substrat, d'au moins un circuit analogique d'amplification et/ou de traitement, puis
- réalisation d'au moins un niveau de circuit intermédiaire sur le niveau de circuit inférieur, puis
- réalisation d'au moins un circuit numérique de traitement dans le niveau de circuit intermédiaire,
- réalisation d'au moins une matrice de dispositifs, configurés pour délivrer en sortie et/ou recevoir en entrée des signaux électriques analogiques, dans un niveau de circuit supérieur, le niveau de circuit intermédiaire étant disposé entre le niveau de circuit supérieur et le niveau de circuit inférieur,
et comportant en outre les étapes de :
- réalisation d'au moins un circuit de conversion analogique - numérique et/ou numérique - analogique formé par des composants microélectroniques réalisés dans le niveau de circuit inférieur au cours d'étapes communes à la réalisation du circuit analogique d'amplification et/ou de traitement et/ou dans le niveau de circuit intermédiaire au cours d'étapes communes à la réalisation du circuit numérique de traitement, et comprenant des entrées et des sorties couplées électriquement à des entrées et/ou des sorties du circuit analogique d'amplification et/ou de traitement ainsi qu'à des entrées et/ou des sorties du circuit numérique de traitement,
- réalisation d'interconnexions électriques traversant le niveau de circuit intermédiaire, couplant électriquement des entrées et/ou des sorties du circuit analogique d'amplification et/ou de traitement à des entrées et/ou des sorties des dispositifs.

Le circuit numérique de traitement peut être réalisé dans le niveau de circuit intermédiaire avec un budget thermique inférieur à environ 500°C. Par exemple, le circuit numérique de traitement peut être réalisé dans le niveau de circuit intermédiaire avec un budget thermique inférieur à 400°C lorsque le niveau de circuit inférieur ne comporte pas d'interconnexions de cuivre ou de portions de siliciure, ou inférieur à environ 500°C dans les autres cas. Un tel budget thermique permet de ne pas endommager les composants analogiques présents dans le niveau de circuit inférieur sur lequel le circuit numérique de traitement est réalisé.

La réalisation du niveau de circuit intermédiaire peut comporter :
- un collage d'un deuxième substrat semi-conducteur sur le niveau de circuit inférieur, puis un amincissement du deuxième substrat semi-conducteur, ou
- un report d'une couche semi-conductrice sur le niveau de circuit inférieur mis en œuvre en utilisant un premier substrat temporaire auquel la couche semi-conductrice est solidarisée, ou
- un dépôt de la couche semi-conductrice sur le niveau de circuit inférieur.

L'expression « couche semi-conductrice » désigne toute couche de matériau présentant des propriétés semi-conductrices, et peut correspondre par exemple à une couche comportant au moins un semi-conducteur amorphe ou polycristallin (par exemple en silicium), ou des nanotubes de carbone (ou CNT), ou au moins un oxyde semi-conducteur, ou au moins un dichalcogénure d'un métal de transition (ou TMD).

La réalisation du niveau de circuit supérieur peut comporter :
- un collage d'un troisième substrat sur le niveau de circuit intermédiaire, puis un amincissement du troisième substrat, ou
- un report, sur le niveau de circuit intermédiaire, d'une couche de matériau servant à la réalisation de la matrice de dispositifs, mis en œuvre en utilisant un deuxième substrat temporaire auquel ladite couche de matériau est solidarisée, ou
- un dépôt de la couche de matériau servant à la réalisation de la matrice de dispositifs sur le niveau de circuit intermédiaire, ou
- un report du niveau de circuit supérieur sur le niveau de circuit intermédiaire.

La couche de matériau servant à la réalisation de la matrice de dispositifs peut correspondre à une couche de semi-conducteur ou à une couche de matériau de photodétection organique ou colloïdale.

Dans le cas d'une intégration séquentielle du niveau de circuit supérieur, c'est-à-dire lorsque la matrice de dispositifs est réalisée après avoir collé et aminci le troisième substrat ou après avoir déposé ou reporté la couche de matériau servant à la réalisation de la matrice de dispositifs, cette matrice est réalisée dans le niveau de circuit supérieur avec un budget thermique adapté pour ne pas endommager les composants se trouvant dans les niveaux de circuit inférieur et intermédiaire, par exemple avec des températures inférieures à environ 400°C ou 500°C.

Dans le cas d'une intégration parallèle du niveau de circuit supérieur, c'est-à-dire lorsque celui-ci est réalisé indépendamment des autres éléments du circuit microélectronique puis reporté ensuite sur le niveau de circuit intermédiaire, les interconnexions électriques de la matrice de dispositifs peuvent être réalisées par l'intermédiaire de plots de contacts présents à l'interface des niveaux de circuit supérieur et intermédiaire, ou par l'intermédiaire d'interconnexions de type TSV réalisées à travers le niveau de circuit supérieur.

L'invention peut s'appliquer avantageusement à un capteur d'images et à son procédé de réalisation. Toutefois, l'invention peut être appliquée à n'importe quel circuit notamment de type détecteur et/ou émetteur, comprenant des capteurs et/ou des émetteurs disposés sous forme de matrice(s) compatible(s) avec les techniques de réalisation du domaine de la microélectronique.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 3 représentent les chemins des données acquises dans différents capteurs tridimensionnels de l'art antérieur ;
- la figure 4 représente schématiquement le chemin de données acquises dans un circuit microélectronique, objet de la présente invention, selon un premier mode de réalisation ;
- les figures 5 à 9 représentent schématiquement des exemples de réalisation d'un circuit microélectronique, objet de la présente invention, selon le premier mode de réalisation ;
- la figure 10 représente schématiquement le chemin de données émises dans un circuit microélectronique, objet de la présente invention, selon un deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

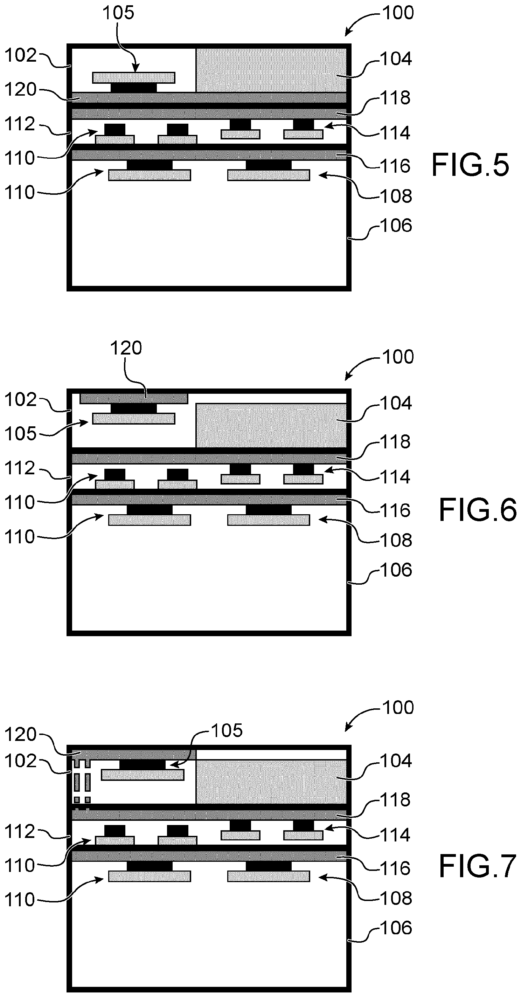

La figure 4 représente schématiquement le chemin de données acquises dans un circuit microélectronique tridimensionnel 100 selon un premier mode de réalisation. Dans ce premier mode de réalisation, le circuit 100 correspond à un capteur d'images, et le chemin de données représenté sur la figure 4 correspond au trajet parcouru par les données acquises, qui correspondent aux images capturées, dans les différents éléments du capteur. Les figures 5 à 9 représentent schématiquement cinq exemples de réalisation d'un tel circuit 100 selon le premier mode de réalisation.

Le circuit 100 comporte un niveau de circuit supérieur 102 dans lequel est réalisée une matrice de dispositifs 104 configurés pour délivrer en sortie et/ou recevoir en entrée des signaux électriques analogiques correspondant aux signaux de données émis et/ou reçus par les dispositifs 104. Dans le premier mode de réalisation décrit ici, les dispositifs 104 comportent des photodétecteurs, par exemple des photodiodes associées chacune à au moins une porte de transfert et/ou au moins un transistor, ou des phototransistors ou des photodiodes formées dans une couche de matériau organique ou colloïdale.

Sur chacune des figures 5 à 7, un dispositif 104 correspondant à une photodiode est représenté, associé à un circuit analogique 105 pouvant comporter des transistors et/ou des capacités et/ou une porte de transfert. Le niveau de circuit supérieur 102 peut comporter une couche de semi-conducteur à partir de laquelle les dispositifs 104 et les circuits analogiques 105 sont réalisés, comme c'est le cas par exemple pour les exemples de réalisation des figures 5 à 7.

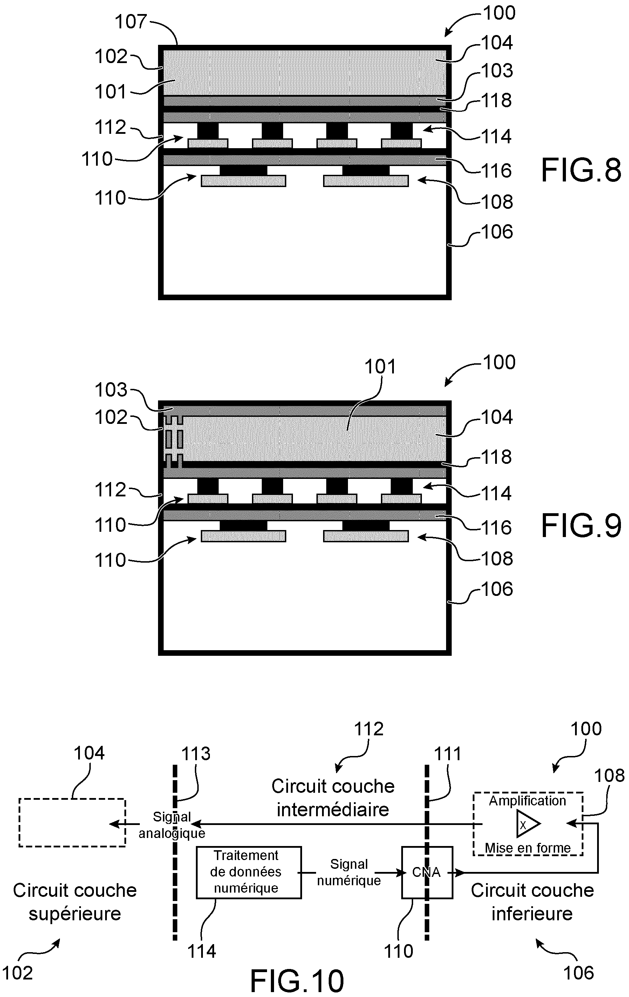

Sur les figures 8 et 9, le niveau de circuit supérieur 102 comporte des dispositifs 104 correspondant à des photodiodes formées par une couche de photodétection 101 organique ou colloïdale et une couche électriquement conductrice 103 formant des électrodes de ces photodiodes.

En variante, les photodétecteurs peuvent correspondre à des éléments de photodétection délivrant en sortie des charges électriques, comme par exemple des éléments de photodétection de type CCD (dispositif à transfert de charge), ou délivrant en sortie des tensions, comme par exemple des éléments de photodétection de type CMOS.

Le circuit 100 comporte également un niveau de circuit inférieur 106 dans lequel les composants microélectroniques servant à la mise en œuvre des fonctions analogiques du circuit 100 sont réalisés, et notamment un circuit analogique 108 d'amplification et/ou de traitement. Dans le premier mode de réalisation décrit ici, le circuit analogique 108 réalise une amplification et une mise en forme des signaux électriques analogiques délivrés par la matrice de photodétecteurs 104. La ou les fonctions mises en œuvre par le circuit analogique 108 correspondent par exemple à une ou plusieurs des fonctions suivantes : compensation d'offset, échantillonnage/blocage, réduction de bruit, amplification, gestion de l'alimentation. A titre d'exemple, le circuit analogique 108 peut mettre en œuvre une fonction de compensation telle que décrite dans le document S.K. Mendis et al., « CMOS active pixel image sensors for highly integrated imaging systems », IEEE JSSC, vol.32, Février 1997. Sur les figures 5 à 9, un transistor MOS analogique est représenté dans la couche inférieure 106 pour symboliser le circuit analogique 108.

Le circuit 100 comporte également un circuit de conversion analogique-numérique et/ou numérique-analogique 110. Dans le premier mode de réalisation décrit ici, le circuit de conversion 110 correspond à plusieurs convertisseurs analogique-numérique (CAN) fonctionnant en parallèle et destinés à convertir en signaux numériques les signaux analogiques délivrés en sortie du circuit analogique 108. Les entrées du circuit de conversion 110 sont couplées électriquement aux sorties du circuit analogique 108. Les convertisseurs analogique-numérique correspondent par exemple à des convertisseurs à rampe et/ou tout autre type de convertisseur. Le circuit de conversion 110 peut délivrer en sortie un ou plusieurs signaux numériques en code binaire.

De manière avantageuse, le circuit de conversion 110 comporte ses composants microélectroniques analogiques réalisés dans le niveau de circuit inférieur 106. Sur les figures 5 à 9, un transistor MOS analogique est représenté dans le niveau de circuit inférieur 106 pour symboliser la partie analogique du circuit de conversion 110.

Le circuit 100 comporte également un niveau de circuit intermédiaire 112 disposé entre le niveau de circuit supérieur 102 et le niveau de circuit inférieur 106. Les trois niveaux de circuit 102, 106 et 112 sont distincts les uns des autres et sont disposés les unes sur les autres en formant un empilement tel que le niveau de circuit intermédiaire 112 soit disposé entre le niveau de circuit inférieur 106 et le niveau de circuit supérieur 102. Sur la figure 4, des traits pointillés portant les références 111 et 113 délimitent symboliquement ces niveaux de circuit.

Les composants microélectroniques servant à la mise en œuvre des fonctions numériques du circuit 100 sont réalisés dans le niveau de circuit intermédiaire 112. Une partie de ces composants microélectroniques forment un circuit numérique 114 destiné à traiter les signaux numériques délivrés par le circuit de conversion 110. Par exemple, le circuit numérique 114 peut permettre de réaliser des fonctions de mémorisation et/ou de détection d'éléments (objets, visages, mouvements, etc.) dans les images capturées par le circuit 100. La ou les fonctions mises en œuvre par le circuit numérique 114 correspondent par exemple à une ou plusieurs des fonctions suivantes : mémorisation, rendu de tons, calcul de couleurs, compression, ou bien encore des fonctions de traitement d'image permettant d'améliorer encore par filtrage la qualité de l'image, la modifier ou d'en extraire des informations utiles par détection (contours, mouvement, vitesse, ...) ou encore de réaliser une reconnaissance de forme, d'objet, de visage, etc. D'autres composants microélectroniques réalisés dans le niveau de circuit intermédiaire 112 servent à former un circuit numérique de contrôle, ou de pilotage, du circuit 100. Ce circuit numérique de contrôle envoie notamment des signaux numériques de commande aux dispositifs 104, et peut également servir au pilotage du circuit de conversion 110. Le circuit 100 comporte des interconnexions électriques entre le niveau de circuit supérieur 102 et le niveau de circuit intermédiaire 112, différentes de celles servant à transmettre les données acquises par les dispositifs 104 et transmises au circuit analogique 108, servant à la transmission de ces signaux numériques de commande. Ce circuit numérique de contrôle et les signaux envoyés par ce circuit numérique de contrôle aux autres éléments du circuit 100 ne sont pas représentés sur la figure 4.

Les sorties du circuit de conversion 110 sont couplées électriquement aux entrées du circuit numérique 114. Sur les figures 5 à 9, des transistors MOS numériques sont représentés dans le niveau de circuit intermédiaire 112 pour symboliser le circuit numérique 114. De plus, le circuit de conversion 110 comporte ses composants microélectroniques numériques réalisés dans le niveau de circuit intermédiaire 112. Sur les figures 5 à 9, un transistor MOS numérique est représenté dans le niveau de circuit intermédiaire 112 pour symboliser la partie numérique du circuit de conversion 110.

Les signaux délivrés par la matrice de dispositifs 104 correspondent à des signaux analogiques envoyés en entrée du circuit analogique 108 par l'intermédiaire d'interconnexions électriques (non visibles sur les figures 5 à 9) allant du niveau de circuit supérieur 102 au niveau de circuit inférieur 106 et traversant le niveau de circuit intermédiaire 112. Le procédé de réalisation du circuit 100 qui est mis en œuvre (et décrit en détails plus loin), et plus particulièrement de la réalisation du niveau de circuit intermédiaire 112, permet de réaliser ces interconnexions électriques avec de faibles dimensions, et donc avec une importante densité, en raison de la faible épaisseur du niveau de circuit intermédiaire 112. Ainsi, il est possible que chaque dispositif 104 de la matrice soit couplé directement à une de ces interconnexions électriques qui est dédiée à ce dispositif 104. En variante, il est possible que chacune de ces interconnexions électriques soit couplée à un groupe de dispositifs 104 formant par exemple une sous-matrice au sein de la matrice formée par l'ensemble des dispositifs 104. Il est également possible que chacune de ces interconnexions électriques soit couplée à une des colonnes ou une des lignes de la matrice de dispositifs 104, notamment lorsque les dispositifs 104 correspondent à des photodétecteurs, comme c'est le cas dans les exemples décrits en lien avec le premier mode de réalisation.

Les signaux analogiques délivrés en sortie du circuit analogique 108 sont envoyés sur les entrées du circuit de conversion analogique - numérique 110. Les signaux numériques délivrés en sortie du circuit de conversion analogique - numérique 110 sont envoyés en entrée du circuit numérique de traitement 114.

Le circuit 100 est obtenu en réalisant tout d'abord dans le niveau de circuit inférieur 106, qui comporte par exemple à un substrat semi-conducteur tel que du silicium, les composants analogiques du circuit 100, c'est-à-dire ici le circuit analogique 108 d'amplification et de mise en forme des signaux délivrés par la matrice de dispositifs 104 ainsi que les composants de la partie analogique du circuit de conversion analogique - numérique 110. Ces composants analogiques incluent notamment des transistors analogiques dont les caractéristiques (notamment les dimensions) permettent un fonctionnement adapté à un environnement analogique, en termes notamment de gain intrinsèque, de bruit, de résistance à l'état passant, etc. Les caractéristiques de ces composants et les techniques mises en œuvre pour les réaliser sont choisies telles qu'elles soient optimales du fait que ces composants analogiques sont réalisés sans la présence d'autres composants limitant le budget thermique des étapes pouvant être mises en œuvre. Ces étapes comportent notamment la mise en œuvre de lithographies, de gravures, de dopages, etc.

Un ou plusieurs niveaux d'interconnexions 116, par exemple métalliques ou comportant du polysilicium fortement dopé, sont ensuite réalisés sur ces composants analogiques. Ces niveaux d'interconnexions 116 sont notamment destinés à assurer les liaisons électriques entre les composants de la partie analogique du circuit de conversion 110 et les composants de la partie numérique du circuit de conversion 110 qui seront réalisés ensuite dans la couche intermédiaire 112, ainsi que les liaisons électriques entre le circuit analogique 108 et la matrice de dispositifs 104.

En variante, il est possible que le niveau de circuit inférieur 106 ne comporte pas le ou les niveaux d'interconnexions 116. Cela peut notamment être le cas lorsque les composants dont les plots de connexions électriques sont présents à l'interface entre les niveaux de circuit inférieur 106 et intermédiaire 112 correspondent à des transistors uniquement. Dans ce cas, les liaisons électriques entre le circuit analogique 108 et la matrice de dispositifs 104 peuvent être réalisées à travers le niveau de circuit intermédiaire 112 en reliant directement le circuit analogique 108 et la matrice de dispositifs 104, sans passer par l'intermédiaire d'un ou plusieurs niveaux d'interconnexions.

Les fonctions numériques du circuit 100 sont ensuite réalisées en technologie 3D séquentielle, formant le niveau de circuit intermédiaire 112.

Selon un exemple de réalisation, une couche de semi-conducteur est formée sur le niveau de circuit inférieur 106. Si les niveaux d'interconnexions 116 sont présents sur le niveau de circuit inférieur 106, ceux-ci sont recouverts d'une couche diélectrique comprenant par exemple de l'oxyde. Une couche d'oxyde peut recouvrir l'une des faces de la couche de semi-conducteur reportée afin qu'un collage oxyde-oxyde puisse être mis en œuvre pour solidariser la couche de semi-conducteur au niveau de circuit inférieur 106. Selon un premier exemple de réalisation, cette couche de semi-conducteur reportée peut correspondre à un substrat qui est aminci après avoir été solidarisé au niveau de circuit inférieur 106. Selon un deuxième exemple de réalisation, cette couche de semi-conducteur reportée peut correspondre à une couche déjà amincie et qui est reportée sur le niveau de circuit inférieur 106 en utilisant un substrat temporaire solidarisé à cette couche amincie et servant à sa manipulation. Ce substrat temporaire est dans ce cas retiré après avoir solidarisé la couche amincie au niveau de circuit inférieur 106. Selon un troisième exemple de réalisation, la couche semi-conductrice du niveau de circuit intermédiaire 112 peut être déposée sur le niveau de circuit inférieur 106. Cette couche semi-conductrice correspond par exemple à une couche comportant au moins un semi-conducteur amorphe ou polycristallin (par exemple en silicium), ou des nanotubes de carbone, ou au moins un oxyde semi-conducteur, ou au moins un dichalcogénure d'un métal de transition.

De manière avantageuse, le niveau de circuit intermédiaire 112 a une épaisseur inférieure à environ 500 nm, ce qui permet de réaliser les interconnexions électriques formant les liaisons électriques entre le circuit analogique 108 et la matrice de dispositifs 104 avec de faibles dimensions, c'est-à-dire chacun avec une section de dimension (diamètre ou diagonale de la section) inférieure à environ 200 nm, et par exemple égale à environ 100 nm. Avec de telles dimensions, ces interconnexions peuvent être réalisées avec des densités par exemple comprises entre 1.10⁶ et 1.10⁹ interconnexions/mm².

Les composants destinés à former le circuit numérique 114 ainsi que les composants de la partie numérique du circuit de conversion 110 sont ensuite réalisés dans la couche semi-conductrice du niveau de circuit intermédiaire 112. Ces composants incluent notamment des transistors CMOS dont les caractéristiques (notamment les dimensions) permettent un fonctionnement adapté dans un environnement numérique, notamment en termes de vitesse et de consommation électrique. Ces étapes comportent notamment la mise en œuvre de lithographies, de gravures, de dopages, etc. Ces étapes sont mises en œuvre à des températures compatibles avec la présence des composants analogiques dans le niveau de circuit inférieur 106, par exemple inférieures à environ 400° voire inférieures à environ 500°C en l'absence d'interconnexions de cuivre ou de portions de siliciure dans le niveau de circuit inférieur 106.

Un ou plusieurs niveaux d'interconnexions métalliques 118 sont ensuite réalisés sur les composants du niveau de circuit intermédiaire 112. Ces niveaux d'interconnexions métalliques 118 sont notamment destinés à assurer les liaisons électriques entre les composants de la partie analogique du circuit de conversion 110 et les composants de la partie numérique de ce circuit de conversion 110, les liaisons électriques entre les sorties du circuit de conversion 110 et la ou les entrées du circuit numérique 114 ainsi que les liaisons électriques entre le circuit analogique 108 et la matrice de dispositifs 104.

Le niveau de circuit supérieur 102 incluant la matrice de dispositifs 104 est ensuite réalisé sur le niveau de circuit intermédiaire 112.

Selon un premier exemple de réalisation visible sur la figure 5, les dispositifs 104 sont réalisés dans la couche supérieure 102 selon une configuration d'illumination face arrière (capteur BSI). Pour cela, les dispositifs 104 ainsi que les éventuels composants microélectroniques associés à ces dispositifs 104 (correspondant au circuit analogique 105 sur l'exemple de la figure 5) sont tout d'abord réalisés dans un substrat semi-conducteur. Les étapes mises en œuvre correspondent notamment à des étapes de lithographie, gravure, dopage, etc. Ces étapes peuvent être mises en œuvre sans limitation sur le budget thermique. Un ou plusieurs niveaux d'interconnexions électriques 120 sont ensuite réalisés sur les dispositifs 104. L'ensemble est ensuite reporté et solidarisé sur le niveau de circuit intermédiaire 112 tel que le ou les niveaux d'interconnexions électriques 120 soient disposés contre le ou les niveaux d'interconnexions électriques 118, les liaisons électriques entre ces niveaux 118 et 120 étant assurées par exemple par l'intermédiaire de plots de contact ou de microbilles (collage hybride). En variante, le report et la solidarisation du niveau de circuit supérieur 102 sur le niveau de circuit intermédiaire 112 peuvent être réalisés en mettant en œuvre un collage oxyde / oxyde, puis en réalisant des contacts traversant de type TSV pour réaliser les liaisons électriques.

Ce report et cette solidarisation correspondent aux techniques mises en œuvre en technologie 3D parallèle. Dans l'exemple décrit ici où les dispositifs 104 correspondent à des photodétecteurs, le substrat semi-conducteur est ensuite aminci jusqu'à ce que les parties photosensibles des photodétecteurs soient aptes à réaliser une photodétection depuis le côté au niveau duquel l'amincissement est réalisé. La figure 5 représente schématiquement le capteur 100 obtenu selon ce premier exemple de réalisation.

En variante, le niveau de circuit supérieur 102 peut être réalisé par la mise en œuvre d'étape d'intégration 3D séquentielle. Pour cela, il est possible de réaliser :
- un collage d'un substrat sur le niveau de circuit intermédiaire 112, puis un amincissement du substrat et une réalisation des dispositifs 104 à partir de la couche restante de cet amincissement de substrat, ou
- un report, sur le niveau de circuit intermédiaire 112, d'une couche de matériau servant à la réalisation de la matrice de dispositifs 104, mis en œuvre en utilisant un substrat temporaire auquel ladite couche de matériau est solidarisée, puis la réalisation des dispositifs 104, ou
- un dépôt de la couche de matériau servant à la réalisation de la matrice de dispositifs 104 directement sur le niveau de circuit intermédiaire 112.

Selon un deuxième exemple de réalisation, les dispositifs 104 sont réalisés dans la couche supérieure 102 selon une configuration d'illumination face avant (capteur FSI). Pour cela, une couche de matériau destinée à servir à la réalisation des dispositifs 104 est reportée sur le niveau de circuit intermédiaire 112, par exemple sur les niveaux d'interconnexions métalliques 118 qui sont recouverts d'une couche diélectrique comprenant par exemple de l'oxyde. Une couche d'oxyde peut recouvrir l'une des faces de la couche de matériau reportée afin qu'un collage oxyde-oxyde puisse être mis en œuvre pour solidariser la couche de matériau au niveau de circuit intermédiaire 112. Comme pour la réalisation du niveau de circuit intermédiaire 112, cette couche de matériau reportée peut correspondre à un substrat qui est alors aminci après avoir été solidarisé au niveau de circuit intermédiaire 112, ou bien cette couche de matériau reportée peut correspondre à une couche déjà amincie et qui est reportée sur le niveau de circuit intermédiaire 112 en utilisant un substrat temporaire solidarisé à cette couche amincie et servant à sa manipulation. Ce substrat temporaire est dans ce cas retiré après avoir solidarisé la couche amincie au niveau de circuit intermédiaire 112.

Les dispositifs 104 et des éventuels composants microélectroniques associés aux dispositifs 104 (correspondant au circuit analogique 105 visible sur la figure 6) sont ensuite réalisés. Comme pour la réalisation des composants numériques dans le niveau de circuit intermédiaire 112, ces étapes sont mises en œuvre à des températures compatibles avec la présence des composants dans les niveaux de circuit inférieur 106 et intermédiaire 112, par exemple inférieures à environ 400°C. Le ou les niveaux d'interconnexions électriques 120 sont ensuite réalisés, puis des interconnexions sont ensuite réalisées à travers la couche supérieure 102 pour assurer les liaisons électriques couplées aux dispositifs semi-conducteurs 104.

Cette réalisation de la couche supérieure 102 et des dispositifs 104 correspond à la technique mise en œuvre en technologie 3D séquentielle. La figure 6 représente schématiquement le capteur 100 obtenu selon ce deuxième exemple de réalisation.

Selon un troisième exemple de réalisation, les dispositifs 104 sont réalisés dans la couche supérieure 102 selon une configuration d'illumination face avant, mais en mettant en œuvre la technologie 3D parallèle. Pour cela, les dispositifs 104 ainsi que les éventuels composants microélectroniques associés à ces dispositifs 104 sont tout d'abord réalisés dans un substrat semi-conducteur. Comme précédemment, les étapes mises en œuvre correspondent notamment à des étapes de lithographie, gravure, dopage, etc. Un ou plusieurs niveaux d'interconnexions électriques 120 sont ensuite réalisés sur les photodétecteurs 104 mais en ne recouvrant pas au moins une partie des zones photosensibles des photodétecteurs 104. L'ensemble est ensuite reporté et solidarisé sur le niveau de circuit intermédiaire 112 tel que le ou les niveaux d'interconnexions électriques 120 soient disposés au niveau de la face avant du circuit 100. Les liaisons électriques entre ce ou ces niveaux 120 et les composants formant la partie analogique du circuit 100 et se trouvant dans le niveau de circuit inférieur 106 sont obtenus en réalisant à travers le niveau de circuit supérieur 102 des interconnexions de type TSV. La figure 7 représente schématiquement le capteur 100 obtenu selon ce troisième exemple de réalisation.

Des détails de réalisation de la technologie 3D séquentielle décrits dans le document [4] de P. Batude et al., « 3D Sequential Integration: Application-driven technological achievements and guidelines », 2017 ISSS International Electron Devices Meeting, San Francisco, USA, 2-6 décembre 2017, peuvent s'appliquer pour la réalisation des composants numériques dans la couche intermédiaire 112 et éventuellement des dispositifs semi-conducteurs dans la couche supérieure 102.

En variante des exemples de réalisation précédemment décrits en lien avec les figures 5 à 7 dans lesquels les dispositifs 104 correspondent à des photodétecteurs semi-conducteurs, les dispositifs 104 peuvent correspondre à des photodétecteurs réalisés dans une couche photosensible organique ou colloïdale. La figure 8 représente un tel exemple de réalisation d'un capteur BSI dans lequel une matrice de photodétecteurs 104 est réalisée dans une couche photosensible 101. Une électrode transparente 107 commune à tous les photodétecteurs 104 est formée sur la couche photosensible 101. Une couche électriquement conductrice 103 est disposée entre la couche photosensible 101 et le niveau de circuit intermédiaire 112. Cette couche 103 est formée de plusieurs portions distinctes formant chacune une deuxième électrode d'un des photodétecteurs 104.

La figure 9 représente un autre exemple de réalisation d'un capteur FSI dans lequel la matrice de photodétecteurs 104 est réalisée dans la couche photosensible 101. L'électrode commune 107 est ici disposée entre la couche photosensible 101 et le niveau de circuit intermédiaire 112, et la couche électriquement conductrice 103 formant les deuxièmes électrodes des photodétecteurs 104 est disposée au niveau de la face avant du circuit 100.

Les différentes possibilités de réalisation du niveau de circuit supérieur 102 précédemment décrites en lien avec les figures 5 à 7 peuvent s'appliquer pour la réalisation du niveau de circuit supérieur 102 du capteur 100 des figures 8 et 9.

Dans le premier mode de réalisation décrit ci-dessus, les composants du circuit de conversion 110 sont réalisés en partie dans le niveau de circuit inférieur 106 et en partie dans le niveau de circuit intermédiaire 112. En variante, il est possible que seule une partie des composants analogiques du circuit de conversion 110 soient réalisés dans le niveau de circuit inférieur 106 et que les autres composants analogiques et les composants numériques du circuit de conversion 110 soient réalisés dans le niveau de circuit intermédiaire 112, ou que seule une partie des composants numériques du circuit de conversion 110 soient réalisés dans le niveau de circuit intermédiaire 112 et que les autres composants numériques et les composants analogiques du circuit de conversion 110 soient réalisés dans le niveau de circuit inférieur 106. Selon une autre variante, il est possible que tous les composants, analogiques et numériques, du circuit de conversion 110 soient réalisés dans le niveau de circuit inférieur 106 ou dans le niveau de circuit intermédiaire 112.

La figure 10 représente schématiquement le chemin de données dans un circuit microélectronique tridimensionnel 100 selon un deuxième mode de réalisation. Dans ce deuxième mode de réalisation, le circuit 100 correspond à un dispositif comportant une matrice de dispositifs semi-conducteurs 104 de type émetteur, par exemple un afficheur, et le chemin de données représenté sur la figure 10 correspond au trajet parcouru par les données à émettre par le circuit 100, par exemple des images à afficher par le circuit 100.

Comme dans le premier mode de réalisation, le circuit 100 comporte l'empilement des trois niveaux de circuit 102, 106 et 112 dans lesquels les composants microélectroniques des différentes fonctions (analogique, numérique, émission) du circuit 100 sont réalisés.

La matrice de dispositifs 104, qui comportent par exemple des diodes électroluminescentes, est réalisée dans le niveau de circuit supérieur 102.

Un circuit numérique 114 est réalisé dans le niveau de circuit intermédiaire 112. Contrairement au premier mode de réalisation dans lequel le circuit numérique 114 forme la fin du chemin de données du circuit 100, le circuit numérique 114 forme, dans ce deuxième mode de réalisation, le début du chemin de données du circuit 100. Autrement dit, les données à émettre ou afficher par le circuit 100 sont émises par ce circuit numérique 114.

Le circuit 100 comporte également le circuit de conversion 110 qui réalise, dans ce deuxième mode de réalisation, une conversion numérique-analogique des données émises par le circuit numérique 114. Sur l'exemple de la figure 10, les composants analogiques et numériques du circuit de conversion 110 sont répartis dans les niveaux de circuit intermédiaire 112 et inférieur 106. Toutefois, les variantes précédemment décrites pour le premier mode de réalisation et qui portent sur la répartition de ces composants au sein du niveau de circuit inférieur 106 et/ou du niveau de circuit intermédiaire 112 s'appliquent également à ce deuxième mode de réalisation.

Les sorties du circuit de conversion 110 sont reliées aux entrées du circuit analogique 108 qui assure l'amplification et la mise en forme des signaux reçus depuis le circuit de conversion 110.

Enfin, le circuit analogique 108 fournit en sortie des signaux à émettre à la matrice de dispositifs semi-conducteurs 104 via des interconnexions électriques traversant le niveau de circuit intermédiaire 112.

Les différents exemples liés à la réalisation du circuit 100 précédemment décrits en lien avec le premier mode de réalisation s'appliquent également à ce deuxième mode de réalisation, les dispositifs 104 pouvant être réalisés en face avant ou en face arrière du niveau de circuit supérieur 102.

Comme dans le premier mode de réalisation, des composants microélectroniques réalisés dans le niveau de circuit intermédiaire 112 servent à former un circuit numérique de contrôle, ou de pilotage, du circuit 100. Ce circuit numérique de contrôle envoie notamment des signaux numériques de commande aux dispositifs 104, et peut également servir au pilotage du circuit de conversion 110. Le circuit 100 comporte des interconnexions électriques entre le niveau de circuit supérieur 102 et le niveau de circuit intermédiaire 112, différentes de celles servant à transmettre les données analogiques transmises depuis le circuit analogique 108, servant à la transmission de ces signaux numériques de commande. Ce circuit numérique de contrôle et les signaux envoyés par ce circuit numérique de contrôle aux autres éléments du circuit 100 ne sont pas représentés sur la figure 10.

Selon d'autres modes de réalisation, le circuit 100 peut comporter une matrice de dispositifs 104 comportant des dispositifs MEMS ou NEMS ou bien des antennes THz. Par exemple, le circuit 100 peut correspondre à un dispositif de mesure de masse moléculaire comprenant une matrice de dispositifs 104 de type NEMS assurant la mesure de masse moléculaire (les dispositifs 104 étant dans ce cas de type détecteur). La matrice de dispositifs 104 de type NEMS est par exemple réalisée en utilisant une couche de polysilicium dans laquelle les dispositifs NEMS sont réalisés par gravure. Le circuit analogique 108 réalise dans ce cas la démodulation et l'amplification des signaux délivrés par la matrice de dispositifs 104, et le circuit numérique 112 assure le traitement des signaux délivrés par le dispositif de conversion 110.

Selon d'autres exemples de réalisation, les dispositifs 104 peuvent correspondre à des capteurs infra-rouges non refroidis ou refroidis, ou bien encore des capteurs de rayons X.

Selon un autre exemple, le circuit 100 peut comporter des dispositifs 104 de type antennes THz, c'est-à-dire aptes à émettre et/ou recevoir des ondes électromagnétiques dans la gamme des THz.

Dans les modes de réalisation précédemment décrits, l'empilement de niveaux de circuits comporte un seul niveau de circuit intermédiaire 112 disposé entre les niveaux de circuit inférieur 106 et supérieur 102. En variante, il est possible que le circuit 100 comporte plusieurs niveaux de circuits intermédiaires 112 distincts, disposés entre les niveaux de circuit inférieur 106 et supérieur 102 et comportant des circuits numériques tels que des circuits mémoires et/ou des circuits de traitement de données. Chacun de ces niveaux de circuit intermédiaires a dans ce cas une épaisseur inférieure à environ 500 nm afin que les composants microélectroniques réalisés dans chacun de ces niveaux de circuit intermédiaires le soient par la mise en œuvre d'une intégration 3D séquentielle. De plus, les interconnexions électriques couplant électriquement des entrées et/ou des sorties du circuit analogique 108 à des entrées et/ou des sorties des dispositifs 104 traversent chacun des niveaux de circuit intermédiaires 112.

Pour tous les modes de réalisation précédemment décrits, le capteur 100 peut comporter d'autres éléments réalisés dans les niveaux de circuit 102, 106, 112. Par exemple, lorsque le circuit 100 correspond à un capteur d'images et que les dispositifs 104 correspondent à des photodétecteurs disposés en matrice, le circuit 100 peut comporter un décodeur de lignes couplé à la matrice de photodétecteurs, et un multiplexeur dont les entrées sont couplées aux sorties du circuit de conversion 110 et dont la sortie est couplée à l'entrée du circuit numérique 114.

### DOCUMENTS CITES

[1] : T. Takahashi et al., "A 4.1Mpix 280fps Stacked CMOS Image Sensor with Array-Parallel ADC Architecture for Region Control", IEEE Symposium on VLSI Circuits (VLSI 2017), Kyoto, Japan, 5-8 juin 2017.
[2] : US 2017/0338268 A1.
[3] : L. Millet et al., "A 5500fps 85GOPS/W 3D stacked BSI vision chip based on parallel in-focal-plane acquisition and processing", IEEE Symposium on VLSI Circuits, Hawaï, USA, 18-22 juin 2018.
[4] : L. Millet et al., "A 5 Million Frames Per Second 3D Stacked Image Sensor With In-Pixel Digital Storage", IEEE ESSCIRC International Conference, Dresden, Germany, 3-6 septembre 2018.
[5] : T. Haruta et al., « A 1/2.3inch 20Mpixel 3-layer stacked CMOS Image Sensor with DRAM », IEEE International Solid-State Circuits Conference (ISSCC 2017), San Francisco, USA, 5-9 février 2017.
[6] : US 2015/0163425 A1

## Revendications

1. Circuit microélectronique (100) comprenant au moins :
- un empilement d'au moins un niveau de circuit inférieur (106), un niveau de circuit intermédiaire (112) et un niveau de circuit supérieur (102), distincts les uns des autres et tels que le niveau de circuit intermédiaire (112) soit disposé entre le niveau de circuit inférieur (106) et le niveau de circuit supérieur (102),
- une matrice de dispositifs (104) configurés pour délivrer en sortie et/ou recevoir en entrée des signaux électriques analogiques, réalisée dans le niveau de circuit supérieur (102),
- un circuit analogique (108) d'amplification et/ou de traitement réalisé dans le niveau de circuit inférieur (106),
- un circuit numérique (114) de traitement réalisé dans le niveau de circuit intermédiaire (112),
- un circuit (110) de conversion analogique - numérique et/ou numérique - analogique formé par des composants microélectroniques réalisés dans le niveau de circuit inférieur (106) et/ou dans le niveau de circuit intermédiaire (112), et comprenant des entrées et des sorties couplées électriquement à des entrées et/ou des sorties du circuit analogique (108) d'amplification et/ou de traitement ainsi qu'à des entrées et/ou des sorties du circuit numérique (114) de traitement,
- des interconnexions électriques traversant le niveau de circuit intermédiaire (112) et couplant électriquement des entrées et/ou des sorties du circuit analogique (108) d'amplification et/ou de traitement à des entrées et/ou des sorties des dispositifs (104).

2. Circuit microélectronique (100) selon la revendication 1, dans lequel le niveau de circuit intermédiaire (112) a une épaisseur inférieure à environ 500 nm, et les interconnexions électriques comportent chacune une section de dimension inférieure à environ 200 nm.

3. Circuit microélectronique (100) selon l'une des revendications précédentes, dans lequel le circuit de conversion (110) analogique-numérique et/ou numérique-analogique comporte des composants microélectroniques analogiques réalisés dans le niveau de circuit inférieur (106) et des composants microélectroniques numériques réalisés dans le niveau de circuit intermédiaire (112).

4. Circuit microélectronique (100) selon l'une des revendications précédentes, dans lequel :
- le nombre d'interconnexions électriques traversant le niveau de circuit intermédiaire (112) et couplant électriquement des entrées et/ou des sorties du circuit analogique (108) d'amplification et/ou de traitement à des entrées et/ou des sorties des dispositifs (104) est au moins égal au nombre de dispositifs (104) tel que chaque dispositif (104) soit couplé directement à l'une de ces interconnexions électriques ; ou
- chacune des interconnexions électriques est couplée à plusieurs dispositifs.

5. Circuit microélectronique (100) selon l'une des revendications précédentes, dans lequel les dispositifs semi-conducteurs (104) comportent des photodétecteurs.

6. Circuit microélectronique (100) selon la revendication 5, dans lequel :
- le niveau de circuit supérieur (102) comporte deux faces principales opposées,
- les photodétecteurs sont couplés électriquement à au moins un niveau de métallisations d'interconnexions (120) disposé du côté d'une première des deux faces principales du niveau de circuit supérieur (102) et en regard du niveau de circuit intermédiaire (112) et comportent des surfaces photosensibles disposées du côté d'une deuxième des deux faces principales du niveau de circuit supérieur (102), ou les photodétecteurs comportent au moins une couche de photodétection organique ou colloïdale et une couche électriquement conductrice formant des électrodes des photodétecteurs telle que la couche électriquement conductrice soit disposée entre la couche de photodétection et le niveau de circuit intermédiaire.

7. Circuit microélectronique (100) selon la revendication 5, dans lequel :
- le niveau de circuit supérieur (102) comporte deux faces principales opposées,
- les photodétecteurs sont couplés électriquement à au moins un niveau de métallisations d'interconnexions (120) disposé du côté d'une première des deux faces principales du niveau de circuit supérieur (102), et comportent des surfaces photosensibles disposées du côté de la première des deux faces principales du niveau de circuit supérieur (102) ou les photodétecteurs comportent au moins une couche de photodétection organique ou colloïdale et une couche électriquement conductrice formant des électrodes des photodétecteurs telle que la couche de photodétection organique ou colloïdale soit disposée entre la couche électriquement conductrice et le niveau de circuit intermédiaire.

8. Circuit microélectronique (100) selon l'une des revendications 1 à 4, dans lequel les dispositifs semi-conducteurs (104) comportent des diodes électroluminescentes ou des dispositifs MEMS ou NEMS ou des antennes THz.

9. Circuit microélectronique (100) selon l'une des revendications précédentes, comportant niveaux de circuit intermédiaires (112) distincts, disposés entre les niveaux de circuit inférieur (106) et supérieur (102) et comportant des circuits numériques (114) tels que des circuits mémoires et/ou des circuits de traitement de données, chaque niveau de circuit intermédiaire (112) ayant une épaisseur inférieure à environ 500 nm, et dans lequel les interconnexions électriques couplant électriquement des entrées et/ou des sorties du circuit analogique (108) d'amplification et/ou de traitement à des entrées et/ou des sorties des dispositifs (104) traversent chacun des niveaux de circuit intermédiaire (112).

10. Procédé de réalisation d'un circuit microélectronique (100), comportant au moins les étapes de :
- réalisation, dans un niveau de circuit inférieur (106) comportant un premier substrat, d'au moins un circuit analogique (108) d'amplification et/ou de traitement, puis
- réalisation d'au moins un niveau de circuit intermédiaire (112) sur le niveau de circuit inférieur (106), puis
- réalisation d'au moins un circuit numérique (114) de traitement dans le niveau de circuit intermédiaire (112),
- réalisation d'au moins une matrice de dispositifs (104), configurés pour délivrer en sortie et/ou recevoir en entrée des signaux électriques analogiques, dans un niveau de circuit supérieur (102), le niveau de circuit intermédiaire (112) étant disposé entre le niveau de circuit supérieur (102) et le niveau de circuit inférieur (106),
et comportant en outre les étapes de :
- réalisation d'au moins un circuit de conversion (110) analogique-numérique et/ou numérique-analogique formé par des composants microélectroniques réalisés dans le niveau de circuit inférieur (106) au cours d'étapes communes à la réalisation du circuit analogique (108) d'amplification et/ou de traitement et/ou dans le niveau de circuit intermédiaire (112) au cours d'étapes communes à la réalisation du circuit numérique (114) de traitement, et comprenant des entrées et des sorties couplées électriquement à des entrées et/ou des sorties du circuit analogique (108) d'amplification et/ou de traitement ainsi qu'à des entrées et/ou des sorties du circuit numérique (114) de traitement,
- réalisation d'interconnexions électriques traversant le niveau de circuit intermédiaire (112), couplant électriquement des entrées et/ou des sorties du circuit analogique (108) d'amplification et/ou de traitement à des entrées et/ou des sorties des dispositifs (104).

11. Procédé selon la revendication 10, dans lequel le circuit numérique (114) de traitement est réalisé dans le niveau de circuit intermédiaire (112) avec un budget thermique inférieur à environ 500°C.

12. Procédé selon l'une des revendications 10 ou 11, dans lequel la réalisation du niveau de circuit intermédiaire (112) comporte :
- un collage d'un deuxième substrat semi-conducteur sur le niveau de circuit inférieur (106), puis un amincissement du deuxième substrat semi-conducteur, ou
- un report d'une couche semi-conductrice sur le niveau de circuit inférieur (106) mis en œuvre en utilisant un premier substrat temporaire auquel la couche semi-conductrice est solidarisée, ou
- un dépôt de la couche semi-conductrice sur le niveau de circuit inférieur.

13. Procédé selon l'une des revendications 10 à 12, dans lequel la réalisation du niveau de circuit supérieur (102) comporte :
- un collage d'un troisième substrat sur le niveau de circuit intermédiaire (112), puis un amincissement du troisième substrat, ou
- un report, sur le niveau de circuit intermédiaire (112), d'une couche de matériau servant à la réalisation de la matrice de dispositifs (104), mis en œuvre en utilisant un deuxième substrat temporaire auquel ladite couche de matériau est solidarisée, ou
- un dépôt de la couche de matériau servant à la réalisation de la matrice de dispositifs sur le niveau de circuit intermédiaire, ou
- un report du niveau de circuit supérieur sur le niveau de circuit intermédiaire.

14. Procédé selon la revendication 13, dans lequel la couche de matériau servant à la réalisation de la matrice de dispositifs (104) correspond à une couche de semi-conducteur ou à une couche de matériau de photodétection organique ou colloïdale.

15. Procédé selon l'une des revendications 13 ou 14, dans lequel la matrice de dispositifs (104) est réalisée dans le niveau de circuit supérieur (102) avec un budget thermique inférieur à environ 500°C.

## Patentansprüche

1. Mikroelektronische Schaltung (100), die mindestens Folgendes umfasst:
- einen Stapel aus mindestens einer unteren Schaltungsebene (106), einer mittleren Schaltungsebene (112) und einer oberen Schaltungsebene (102), die voneinander verschieden und derart sind, dass die mittlere Schaltungsebene (112) zwischen der unteren Schaltungsebene (106) und der oberen Schaltungsebene (102) angeordnet ist,
- eine Matrix aus Vorrichtungen (104), die dazu konfiguriert sind, analoge elektrische Signale am Ausgang zu liefern und/oder am Eingang zu empfangen, die in der oberen Schaltungsebene (102) hergestellt ist,
- eine analoge Verstärkungs- und/oder Verarbeitungsschaltung (108), die in der unteren Schaltungsebene (106) hergestellt ist,
- eine digitale Verarbeitungsschaltung (114), die in der mittleren Schaltungsebene (112) hergestellt ist,
- eine Analog-Digital- und/oder Digital-Analog-Umwandlungsschaltung (110), die aus mikroelektronischen Komponenten ausgebildet ist, die in der unteren Schaltungsebene (106) und/oder in der mittleren Schaltungsebene (112) hergestellt sind, und Eingänge und Ausgänge umfasst, die elektrisch mit Eingängen und/oder Ausgängen der analogen Verstärkungs- und/oder Verarbeitungsschaltung (108) sowie mit Eingängen und/oder Ausgängen der digitalen Verarbeitungsschaltung (114) gekoppelt sind,
- elektrische Verbindungen, die durch die mittlere Schaltungsebene (112) verlaufen und Eingänge und/oder Ausgänge der analogen Verstärkungs- und/oder Verarbeitungsschaltung (108) elektrisch mit Eingängen und/oder Ausgängen der Vorrichtungen (104) koppeln.

2. Mikroelektronische Schaltung (100) nach Anspruch 1, wobei die mittlere Schaltungsebene (112) eine Dicke von weniger als etwa 500 nm aufweist, und die elektrischen Verbindungen jeweils einen Querschnitt mit einer Abmessung von weniger als etwa 200 nm aufweisen.

3. Mikroelektronische Schaltung (100) nach einem der vorhergehenden Ansprüche, wobei die Analog-Digital- und/oder Digital-Analog-Umwandlungsschaltung (110) analoge mikroelektronische Komponenten, die in der unteren Schaltungsebene (106) hergestellt sind, und digitale mikroelektronische Komponenten umfasst, die in der mittleren Schaltungsebene (112) hergestellt sind.

4. Mikroelektronische Schaltung (100) nach einem der vorhergehenden Ansprüche, wobei:
- die Anzahl der elektrischen Verbindungen, die durch die mittlere Schaltungsebene (112) verlaufen und Eingänge und/oder Ausgänge der analogen Verstärkungs- und/oder Verarbeitungsschaltung (108) elektrisch mit Eingängen und/oder Ausgängen der Vorrichtungen (104) koppeln, mindestens gleich der Anzahl der Vorrichtungen (104) ist, so dass jede Vorrichtung (104) direkt mit einer der elektrischen Verbindungen gekoppelt ist; oder
- jede der elektrischen Verbindungen mit mehreren Vorrichtungen gekoppelt ist.

5. Mikroelektronische Schaltung (100) nach einem der vorhergehenden Ansprüche, wobei die Halbleitervorrichtungen (104) Fotodetektoren umfassen.

6. Mikroelektronische Schaltung (100) nach Anspruch 5, wobei:
- die obere Schaltungsebene (102) zwei gegenüberliegende Hauptflächen umfasst,
- die Fotodetektoren elektrisch mit mindestens einer Verbindungsmetallisierungsebene (120) gekoppelt ist, die auf der Seite einer ersten der beiden Hauptflächen der oberen Schaltungsebene (102) und gegenüber der mittleren Schaltungsebene (112) angeordnet ist, und lichtempfindliche Oberflächen umfassen, die auf der Seite einer zweiten der beiden Hauptflächen der oberen Schaltungsebene (102) angeordnet sind, oder die Fotodetektoren mindestens eine organische oder kolloidale Fotodetektionsschicht und eine elektrisch leitende Schicht umfassen, die Elektroden der Fotodetektoren bildet, so dass die elektrisch leitende Schicht zwischen der Fotodetektionsschicht und der mittleren Schaltungsebene angeordnet ist.

7. Mikroelektronische Schaltung (100) nach Anspruch 5, wobei:
- die obere Schaltungsebene (102) zwei gegenüberliegende Hauptflächen umfasst,
- die Fotodetektoren elektrisch mit mindestens einer Verbindungsmetallisierungsebene (120) gekoppelt sind, die auf der Seite einer ersten der beiden Hauptflächen der oberen Schaltungsebene (102) angeordnet ist, und lichtempfindliche Oberflächen umfassen, die auf der Seite der ersten der beiden Hauptoberflächen der oberen Schaltungsebene (102) angeordnet sind, oder die Fotodetektoren mindestens eine organische oder kolloidale Fotodetektionsschicht und eine elektrisch leitende Schicht umfassen, die Elektroden der Fotodetektoren bildet, so dass die organische oder kolloidale Fotodetektionsschicht zwischen der elektrisch leitenden Schicht und der mittleren Schaltungsebene angeordnet ist.

8. Mikroelektronische Schaltung (100) nach einem der Ansprüche 1 bis 4, wobei die Halbleitervorrichtungen (104) lichtemittierende Dioden oder MEMS- oder NEMS-Vorrichtungen oder THz-Antennen umfassen.

9. Mikroelektronische Schaltung (100) nach einem der vorhergehenden Ansprüche, die verschiedene mittlere Schaltungsebenen (112) umfasst, die zwischen der unteren (106) und der oberen (102) Schaltungsebene angeordnet sind und digitale Schaltungen (114) wie Speicherschaltungen und/oder Datenverarbeitungsschaltungen umfassen, wobei jede mittlere Schaltungsebene (112) eine Dicke von weniger als etwa 500 nm aufweist, und wobei die elektrischen Verbindungen, die Eingänge und/oder Ausgänge der analogen Verstärkungs- und/oder Verarbeitungsschaltung (108) elektrisch mit Eingängen und/oder Ausgängen der Vorrichtungen (104) verbinden, durch jede der mittleren Schaltungsebenen (112) verlaufen.

10. Verfahren zum Herstellen einer mikroelektronischen Schaltung (100), das mindestens die folgenden Schritte umfasst:
- Herstellen mindestens einer analogen Verstärkungs- und/oder Verarbeitungsschaltung (108) in einer unteren Schaltungsebene (106), die ein erstes Substrat umfasst, anschließend
- Herstellen mindestens einer mittleren Schaltungsebene (112) auf der unteren Schaltungsebene (106), anschließend
- Herstellen mindestens einer digitalen Verarbeitungsschaltung (114) in der mittleren Schaltungsebene (112),
- Herstellen mindestens einer Matrix aus Vorrichtungen (104), die dazu konfiguriert sind, analoge elektrische Signale am Ausgang zu liefern und/oder am Eingang zu empfangen, in einer oberen Schaltungsebene (102), wobei die mittlere Schaltungsebene (112) zwischen der oberen Schaltungsebene (102) und der unteren Schaltungsebene (106) angeordnet ist,
und ferner die folgenden Schritte umfasst:
- Herstellen mindestens einer Analog-Digital- und/oder Digital-Analog-Umwandlungsschaltung (110), die aus mikroelektronischen Komponenten ausgebildet ist, die in der unteren Schaltungsebene (106) während gemeinsamer Schritte zum Herstellen der analogen Verstärkungs- und/oder Verarbeitungsschaltung (108) und/oder in der mittleren Schaltungsebene (112) während gemeinsamer Schritte zum Herstellen der digitalen Verarbeitungsschaltung (114) hergestellt werden, und Eingänge und Ausgänge umfasst, die elektrisch mit Eingängen und/oder Ausgängen der analogen Verstärkungs- und/oder Verarbeitungsschaltung (108) sowie mit Eingängen und/oder Ausgängen der digitalen Verarbeitungsschaltung (114) gekoppelt sind,
- Herstellen elektrischer Verbindungen, die durch die mittlere Schaltungsebene (112) verlaufen und Eingänge und/oder Ausgänge der analogen Verstärkungs- und/oder Verarbeitungsschaltung (108) elektrisch mit Eingängen und/oder Ausgängen der Vorrichtungen (104) koppeln.

11. Verfahren nach Anspruch 10, wobei die digitale Verarbeitungsschaltung (114) in der mittleren Schaltungsebene (112) mit einem Wärmehaushalt von weniger als etwa 500 °C hergestellt wird.

12. Verfahren nach einem der Ansprüche 10 oder 11, wobei das Herstellen der mittleren Schaltungsebene (112) Folgendes umfasst:
- Bonden eines zweiten Halbleitersubstrats an die untere Schaltungsebene (106), anschließend Ausdünnen des zweiten Halbleitersubstrats, oder
- Übertragen einer Halbleiterschicht auf die untere Schaltungsebene (106), das unter Verwendung eines ersten temporären Substrats, an dem die Halbleiterschicht befestigt ist, durchgeführt wird, oder
- Abscheiden der Halbleiterschicht auf die untere Schaltungsebene.

13. Verfahren nach einem der Ansprüche 10 bis 12, wobei das Herstellen der oberen Schaltungsebene (102) Folgendes umfasst:
- Bonden eines dritten Substrats an die mittlere Schaltungsebene (112), anschließend Ausdünnen des dritten Substrats, oder
- Übertragen einer Materialschicht, die zum Herstellen der Matrix aus Vorrichtungen (104) verwendet wird, auf die mittlere Schaltungsebene (112), das unter Verwendung eines zweiten temporären Substrats, an dem die Materialschicht befestigt ist, durchgeführt wird, oder
- Abscheiden der Materialschicht, die zum Herstellen der Matrix aus Vorrichtungen verwendet wird, auf die mittlere Schaltungsebene, oder
- Übertragen der oberen Schaltungsebene auf die mittlere Schaltungsebene.

14. Verfahren nach Anspruch 13, wobei die Materialschicht, die zum Herstellen der Matrix aus Vorrichtungen (104) verwendet wird, einer Halbleiterschicht oder einer Schicht aus organischem oder kolloidalem Fotodetektionsmaterial entspricht.

15. Verfahren nach einem der Ansprüche 13 oder 14, wobei die Matrix aus Vorrichtungen (104) in der oberen Schaltungsebene (102) mit einem Wärmehaushalt von weniger als etwa 500 °C hergestellt wird.

## Claims

1. A microelectronic circuit (100) comprising at least:
- a stack of a lower circuit tier (106), an intermediate circuit tier (112), and an upper circuit tier (102), distinct from each other and such that the intermediate circuit tier (112) is disposed between the lower circuit tier (106) and the upper circuit tier (102),
- a matrix of devices (104) configured to output and/or receive as an input analogue electrical signals, made in the upper circuit tier (102),
- an analogue amplification and/or processing circuit (108) made in the lower circuit tier (106),
- a digital processing circuit (114) made in the intermediate circuit tier (112),
- an analogue-to-digital and/or digital-to-analogue conversion circuit (110) formed by microelectronic components made in the lower circuit tier (106) and/or in the intermediate circuit tier (112), and comprising inputs and outputs electrically coupled to inputs and/or outputs of the analogue amplification and/or processing circuit (108) and to inputs and/or outputs of the digital processing circuit (114),
- electrical interconnections passing through the intermediate circuit tier (112) and electrically coupling inputs and/or outputs of the analogue amplification and/or processing circuit (108) to inputs and/or outputs of the devices (104).

2. The microelectronic circuit (100) according to claim 1, wherein the intermediate circuit tier (112) has a thickness of less than about 500 nm, and the electrical interconnections each have a cross-section with a dimension of less than about 200 nm.

3. The microelectronic circuit (100) according to claim 1, wherein the analogue-to-digital and/or digital-to-analogue conversion circuit (110) includes analogue microelectronic components made in the lower circuit tier (106) and digital microelectronic components made in the intermediate circuit tier (112) .

4. The microelectronic circuit (100) according to claim 1, wherein:
- the number of electrical interconnections passing through the intermediate circuit tier (112) and electrically coupling inputs and/or outputs of the analogue amplification and/or processing circuit (108) to inputs and/or outputs of the devices (104) is at least equal to the number of devices (104) such that each device (104) is directly coupled to one of these electrical interconnections; or
- each of the electrical interconnections is coupled to several devices.

5. The microelectronic circuit (100) according to claim 1, wherein the semiconductor devices (104) include photodetectors.

6. The microelectronic circuit (100) according to claim 5, wherein:
- the upper circuit tier (102) includes two opposite main faces,
- the photodetectors are electrically coupled to at least one interconnection metallisation tier (120) disposed on the side of a first of both main faces of the upper circuit tier (102) and facing the intermediate circuit tier (112) and include photosensitive surfaces disposed on the side of a second of both main faces of the upper circuit tier (102), or the photodetectors include at least one organic or colloidal photodetection layer and an electrically conductive layer forming electrodes of the photodetectors such that the electrically conductive layer is disposed between the photodetection layer and the intermediate circuit tier.

7. The microelectronic circuit (100) according to claim 5, wherein:
- the upper circuit tier (102) includes two opposite main faces,
- the photodetectors are electrically coupled to at least one interconnection metallisation tier (120) disposed on the side of a first of both main faces of the upper circuit tier (102) and include photosensitive surfaces disposed on the side of the first of both main faces of the upper circuit tier (102) or the photodetectors include at least one organic or colloidal photodetection layer and an electrically conductive layer forming electrodes of the photodetectors such that the organic or colloidal photodetection layer is disposed between the electrically conductive layer and the intermediate circuit tier.

8. The microelectronic circuit (100) according to claim 1, wherein the semiconductor devices (104) include light emitting diodes or MEMS or NEMS devices or THz antennas.

9. The microelectronic circuit (100) according to claim 1, including distinct intermediate circuit tiers (112) disposed between the lower (106) and upper circuit tiers (102) and including digital circuits (114) such as memory circuits and/or data processing circuits, each intermediate circuit tier (112) having a thickness of less than about 500 nm, and wherein the electrical interconnections electrically coupling inputs and/or outputs of the analogue amplification and/or processing circuit (108) to inputs and/or outputs of the devices (104) pass through each of the intermediate circuit tiers (112).

10. A method for making a microelectronic circuit (100), including at least the steps of:
- making, in a lower circuit tier (106) including a first substrate, at least one analogue amplification and/or processing circuit (108), and then
- making at least one intermediate circuit tier (112) on the lower circuit tier (106), and then
- making at least one digital processing circuit (114) in the intermediate circuit tier (112),
- making at least one matrix of devices (104), configured to output and/or receive as an input analogue electrical signals, in an upper circuit tier (102), wherein the intermediate circuit tier (112) is disposed between the upper circuit tier (102) and the lower circuit tier (106),
and further including the steps of:
- making at least one analogue-to-digital and/or digital-to-analogue conversion circuit (110) formed by microelectronic components made in the lower circuit tier (106) during steps common to making of the analogue amplification and/or processing circuit (108) and/or in the intermediate circuit tier (112) during steps common to making of the digital processing circuit (114), and comprising inputs and outputs electrically coupled to inputs and/or outputs of the analogue amplification and/or processing circuit (108) as well as to inputs and/or outputs of the digital processing circuit (114),
- making electrical interconnections passing through the intermediate circuit tier (112), electrically coupling inputs and/or outputs of the analogue amplification and/or processing circuit (108) to inputs and/or outputs of the devices (104).

11. The method according to claim 10, wherein the digital processing circuit (114) is made in the intermediate circuit tier (112) with a thermal budget of less than about 500°C.

12. The method according to claim 10, wherein making the intermediate circuit tier (112) includes:
- bonding a second semiconductor substrate to the lower circuit tier (106), and then thinning the second semiconductor substrate, or
- transferring a semiconductor layer to the lower circuit tier (106) implemented using a first temporary substrate to which the semiconductor layer is secured, or
- depositing the semiconductor layer onto the lower circuit tier.

13. The method according to claim 10, wherein making the upper circuit tier (102) includes:
- bonding a third substrate to the intermediate circuit tier (112), and then thinning the third substrate, or
- transferring a layer of material, used for making the matrix of devices (104), to the intermediate circuit tier (112) implemented using a second temporary substrate to which said layer of material is secured, or
- depositing the layer of material used for making the matrix of devices onto the intermediate circuit tier, or
- transferring the upper circuit tier to the intermediate circuit tier.

14. The method according to claim 13, wherein the layer of material used for making the matrix of devices (104) corresponds to a semiconductor layer or to an organic or colloidal photodetection material layer.

15. The method according to claim 13, wherein the matrix of devices (104) is made in the upper circuit tier (102) with a thermal budget of less than about 500°C.
